(19) Europäisches Patentamt
European Patent Office
Office européen des brevets

(11) **EP 2 481 462 A1**

(12) **EUROPEAN PATENT APPLICATION**

(43) Date of publication:
**01.08.2012 Bulletin 2012/31**

(21) Application number: **11175214.3**

(22) Date of filing: **25.07.2011**

(51) Int Cl.:
*B01D 39/16* (2006.01)   *B01D 69/02* (2006.01)
*B01D 69/10* (2006.01)   *B01D 71/26* (2006.01)
*B01D 71/36* (2006.01)   *B29K 105/04* (2006.01)
*F21S 4/00* (2006.01)   *H05K 5/03* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.07.2010 US 842193**

(71) Applicant: **EF-Materials Industries, Inc.**
**Chung-Li 32065 (CN)**

(72) Inventors:
• **Huang, James**
  **408 Taichung City (TW)**

• **Chen, Sean**
  **320 Zhongli City, Taoyuan County (TW)**
• **Han, Jeff**
  **320 Zhongli City, Taoyuan County (TW)**
• **Chin, Chung Sung**
  **350 Zhunan Township, Miaoli County (TW)**
• **Huang, Radium**
  **408 Taichung City (TW)**

(74) Representative: **Vossius & Partner**
**Siebertstrasse 4**
**81675 München (DE)**

(54) **Water-proof and dust-proof membrane assembly and applications thereof**

(57)    A water-proof and dust-proof membrane assembly which has a satisfactory water-proof property, dust-proof property, sound transmission capability and air permeability, as well as excellent supporting intensity and pressure resistance is provided. A water-proof and dust-proof membrane assembly having a body and a supporting member, in which the body is an asymmetric porous structure in the form of membrane having a first surface and a second surface, the supporting member is composed of a polymeric material, includes a first contact surface and a second contact surface and the porosity (second porosity) of the supporting member is larger than the first porosity, i.e. 10% to 99.9%, and the first surface of the body and the first contact surface of the supporting body are bonded is provided.

**EP 2 481 462 A1**

**Description**

TECHNICAL FIELD

The present invention relates to water-proof and dust-proof membrane assembly and an apparatus using the assembly.

BACKGROUND ART

The advancement of science has improved the quality of human life and has made electronic products essential to human life. Examples of such electronic products are consumptive electronic products such as cell phones, digital cameras, MP3 players, MP4 players, PDAs and the like: general outdoor electronic products such as security monitoring camera systems, outdoor lightings, traffic lights, underwater electronic products, marine electronic products, telecommunication devices and the like: and medical electronic products.

Housings of various outdoor electronic products are always exposed to temperature variation, weather corrosion and solar radiation. Also, sudden drop of the ambient temperature causes unbalanced air pressure between the inside and the outside of the housing. For this reason, air or moisture enters the housing and electronic circuits which are sensitive to air and moisture cause corrosion inside the housing, thereby inducing breakdown or damage. In addition, consumptive electronic products without water-proof and dust-proof functions are, when splashed by water or other liquids accidentally or when frequently used, likely to get damaged because of liquids or dust entering into the electronic circuit thereof. Therefore, the related manufacturers have paid much attention to continuously improve practicability and durability of the existing electronic products.

One major factor for prolonging the service life of electronic products is to keep internal electronic circuits functioning normally. In order to ensure the sensitivity of electronic products, to secure normal operation of their internal electronic circuit and further, to enable the electronic products to continue good operation even in adverse circumstances, factors including water-proof function, dust-proof function, corrosion resistance and air permeability need to be further considered.

Currently, it is common to use a porous film as a protective film. Specifically, many porous films are made of fluorinated polymeric materials such as fluoropolymer, fluorinated ethylene-propylene copolymer (FEP), polytetrafluoroethylene (PTFE) and polyvinylidene fluoride (PVDF).

PTFE porous films have excellent water repellency at its surface and show the largest water contact angle among the above materials. Therefore, the PTFE porous films are hardly wetted by general liquids and hardly bonded to other materials.

A PTFE porous film is produced according to a disclosed process (for example, Patent Documents 1 to 3). The obtained PTFE porous film can be made into a porous film with 1 billion to 15 billion micro-pores per square inch which has excellent air permeability. Further, the above PTFE porous film has an average pore size of 0.25 to 0.55 $\mu$m, which is ten-thousandth as large as a raindrop while 700 times larger than a sweat vapor molecule or a water vapor molecule, and thus the PTFE porous film is advantageous as an air permeable and water-proof film.

The internal network structure formed with the microfibers of the PTFE porous film has heat resistance and surface lubricity in nature, and dust adsorbed on the film surface can be easily removed. The above PTFE porous film may be made with different pore sizes and laminated with various fabrics for being used for materials requiring dustproof function. Therefore, the PTFE porous film is useful for dust-proof and filtering purposes.

PRIOR ART DOCUMENT

Patent Document

[Patent Document 1] The United States Patent No. 3953566

[Patent Document 2] The United States Patent No. 3962153

[Patent Document 3] The United States Patent No. 4902423

DISCLOSURE OF THE INVENTION

Problem to be solved by the invention

A protective film of this kind prepared from a PTFE porous film having water-proof property, sound transmission capability, dust-proof property and air permeability needs to be provided with different levels of water-proof property, sound transmission capability and air permeability when applied to different products. It is known that the water-proof property of the PTFE porous film is enhanced by decreasing the average pore size thereof. However, water-proof property and air permeability usually spoil each other's performance; in other words, water-proof property and air permeability are in a trade-off relationship. In addition, sound transmission capability and water-proof property are also in a trade-off relationship. To be brief, a decreased average pore size lowers air permeability as well as sound transmission capability. Accordingly, it is not easy to enhance the water-proof property without lowering air permeability and sound transmission capability. While there are commercially available protective film products made of a PTFE porous film, one with high air permeability and high sound transmission capability has a relatively large pore size, which suggests weakened water-proof property. On the other hand, one having a relatively small pore size to present good water-proof property often suffers from lowered air permeability and sound transmission capability.

The above common electronic products and water-proof electronic products need an appropriate protective film made of a PTFE porous film for protecting the internal electronic circuits, and many non-electronic products with special requirements regarding water-proof capability and air permeability also need such protective film. Therefore, a problem to be solved by the invention is how to make a protective film for protecting products and prolonging the service life of the products, which has satisfactory water-proof property, dust-proof capability and air permeability, and is adaptive to various products.

Means for solving the problem

Accordingly, a main object of the present invention is to provide a water-proof and dust-proof membrane assembly which has a satisfactory water-proof property, dust-proof property, sound transmission capability and air permeability, as well as excellent supporting strength and pressure resistance.

In order to solve the above problem, the present invention provides a water-proof and dust-proof membrane assembly, which comprises a body and a supporting member. The body is an asymmetric porous structure in the form of membrane having a first surface and a second surface. The asymmetric porous structure has a thickness of 1 to 1,000 $\mu$m, a porosity (first porosity) of 5% to 99%, a pore size of each pore of 0.01 to 15 $\mu$m, a Frazier air permeability of 10 $\times$ 104ft$^3$/minft$^2$ to 60 $\times$ 10$^4$ft$^3$/minft$^2$, and a Gurley number of 0.3 to 25 seconds. The supporting member is composed of a polymeric material, and includes a first contact surface and a second contact surface. The porosity (second porosity) of the supporting member is greater than the first porosity, i.e. 10% to 99.9%, and the first contact surface of the supporting member is bonded to the first surface of the body.

The asymmetric porous structure has a dense skin layer and a continuously foamed porous layer and it is preferable that the skin layer makes up 0.04 to 40% of the thickness of the asymmetric porous structure. It is also preferable that the water contact angle of the skin layer is 120° to 135°.

The asymmetric porous structure may have the skin layer on the surface of either the first surface or the second surface. Also, the asymmetric porous structure may have the skin layer on the both surfaces of the first surface and the second surface.

The asymmetric porous structure is produced by heat-treating a symmetric porous structure, and it is preferable that the Frazier air permeability after the heat treatment is 1.1 to 2.5 times that before the heat treatment.

The collecting efficiency of the asymmetric porous structure is preferably 99.50 to 99.99%.

In the water-proof and dust-proof membrane assembly using the asymmetric porous structure in which the skin layer is provided on either of the first surface side or the second surface side, it is preferable that its water pressure resistance is 3,000 to 20,000 mmH$_2$O, its air permeability is 0.42 to 6.1 cm$^3$/cm$^2$/sec., and its sound transmission loss is 0.5 to 2.5 dB. In the water-proof and dust-proof membrane assembly using the asymmetric porous structure in which the skin layer is provided on the first surface side and the second surface side, it is preferable that its water pressure resistance is 5,000 to 20,000 mmH$_2$O, its air permeability is 0.1 to 0.34 cm$^3$/cm$^2$/sec., and its sound transmission loss is 0.5 to 2.5 dB.

The body is preferably formed by a film selected from a resin porous film or a fluorine-containing polymer film. The preferable resin porous film is an ultrahigh molecular weight polyethylene porous film or a polytetrafluoroethylene film, and the preferable fluorine-containing polymer film is one prepared from a partially fluorinated polymer or a completely fluorinated polymer.

It is another object of the present invention to provide a water-proof and dust-proof membrane assembly, which has excellent supporting strength and pressure resistance and thereby being adaptive to underwater products.

Further, it is yet another object of the present invention to provide an electronic device and a lighting system provided with the water-proof and dust-proof membrane assembly having satisfactory water-proof property, dust-proof property, sound transmission capability as well as air permeability.

EFFECT OF THE INVENTION

The water-proof and dust-proof membrane assembly of the present invention is provided with a body and a supporting member. The body is an asymmetric porous structure in the form of membrane having a first surface and a second surface. The asymmetric porous structure has a thickness of 1 to 1,000 $\mu$m, a porosity (first porosity) of 5% to 99%, a pore size of each pore of 0.01 to 15 $\mu$m, a Frazier air permeability of $10 \times 10^4 \mathrm{ft}^3/\mathrm{minft}^2$ to $60 \times 10^4 \mathrm{ft}^3/\mathrm{minft}^2$, and a Gurley number of 0.3 to 25 seconds. By using such body, it is possible to provide a water-proof and dust-proof membrane assembly which has a satisfactory water-proof property, dust-proof property, sound transmission capability and air permeability, without losing the performances which are generally in a trade-off relationship, such as water-proof property and air permeability or sound transmission capability and water-proof property.

Moreover, the water-proof and dust-proof membrane assembly is provided with a supporting member. As a result, it is possible to provide a water-proof and dust-proof membrane assembly which has excellent supporting strength and pressure resistance.

BRIEF DESCRIPTION OF THE DRAWINGS

Fig. 1 is a schematic sectional view of the water-proof and dust-proof membrane assembly according to a first embodiment of the present invention.

Fig. 2 is a schematic sectional view of the water-proof and dust-proof membrane assembly according to a second embodiment of the present invention.

Fig. 3 is a schematic sectional view of the water-proof and dust-proof membrane assembly according to a third embodiment of the present invention.

Fig. 4 is a schematic view explaining the way of heat treatment for forming a skin layer in the water-proof and dust-proof membrane assembly according to a third embodiment of the present invention.

Fig. 5 is a schematic view of a cell phone using the water-proof and dust-proof membrane assembly of the present invention.

Fig. 6 is a schematic view of an underwater digital camera using the water-proof and dust-proof membrane assembly of the present invention.

Fig. 7 is a schematic view of a lighting system using the water-proof and dust-proof membrane assembly of the present invention.

Fig. 8 is a schematic view of a container using the water-proof and dust-proof membrane assembly of the present invention.

Fig. 9 is a graph evaluating the relation between the Gurley number and the sound transmission loss of the water-proof and dust-proof membrane assembly of the present invention.

Fig. 10 is a graph evaluating the relation between the Gurley number and the water pressure resistance (water intrusion pressure) of the water-proof and dust-proof membrane assembly of the present invention.

EMBODIMENT FOR CARRYING OUT THE INVENTION

[Embodiment 1]

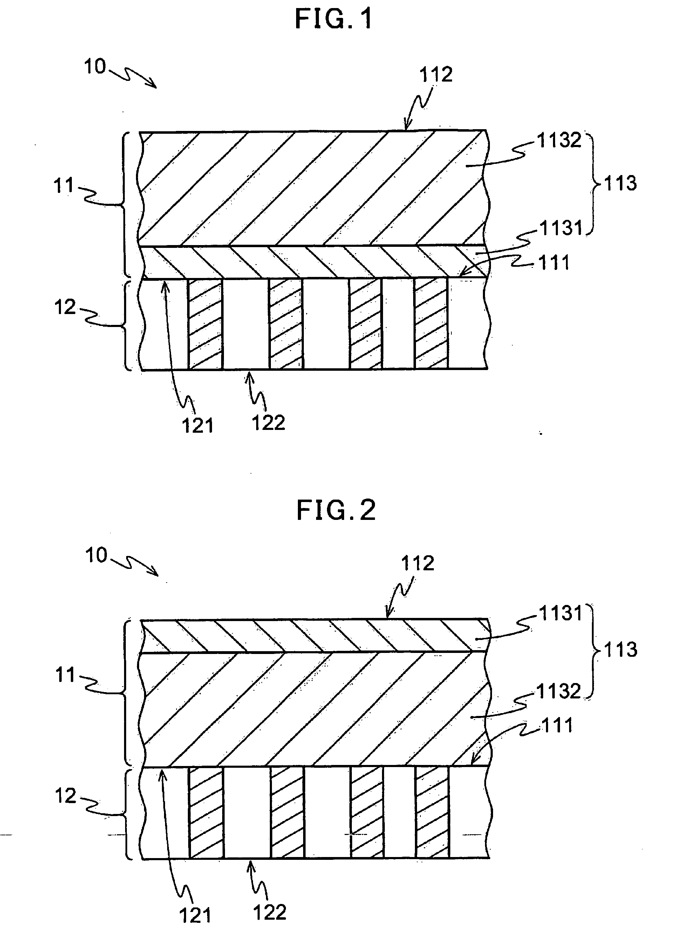

Hereinafter, the water-proof and dust-proof membrane assembly according to the first embodiment of the present invention will be explained using the drawings. Fig. 1 is a schematic sectional view of the water-proof and dust-proof membrane assembly according to the first embodiment of the present invention. As shown in Fig. 1, the water-proof and dust-proof membrane assembly 10 according to the first embodiment of the present invention has a body 11 and a supporting member 12. The body 11 is an asymmetric porous structure 113 in the form of membrane having a first surface 111 and a second surface 112. The asymmetric porous structure 113 in the form of membrane is composed of a skin layer 1131 and a continuously foamed 1132. The supporting member 12 is composed of a polymeric material and includes a first contact surface 121 and a second contact surface 122. The body 11 and the supporting member 12 are bonded to each other between the first surface 111 of the body and the first contact surface 121 of the supporting member.

[Body]

(Material)

A material of the body is not limited as long as the material can form an asymmetric porous structure in the form of membrane. Preferable materials are resins such as an ultrahigh molecular weight polyethylene and polytetrafluoroethylene, and fluorine-containing polymers such as a partially fluorinated polymer and a completely fluorinated polymer (except polytetrafluoroethylene). Among these, an especially preferable material is polytetrafluoroethylene (hereinafter, referred to as "PTFE"), and a method of forming the asymmetric porous structure 113 in the form of membrane using PTFE will be explained below.

In the specification, a symmetric porous film refers to the one in which pores having a defined average pore size exist over the film uniformly. Further, the asymmetric porous structure 113 refers to the one having a surface (skin surface 1131) whose porous structure is further densified by heat-treating the surface of the symmetric porous film, and it is also the one in which pores having a defined average pore size exist over the film uniformly. The continuously foamed porous layer refers to the one that while heat treatment the pore diameter and pore structure of the symmetric porous film remain substantially unchanged.

The asymmetric porous structure 113 used in this embodiment can be produced basically according to the following six known processes.

(1) Paste extrusion process of PTFE fine powder

A paste mixture of PTFE fine powder obtained by an emulsion polymerization method and extrusion aids such as naphtha is extruded with an extruder to obtain an extrudate in the form of column, rectangular column or sheet.

Here, PTFE fine powder is the dried powder of a polymer separated by coagulating aqueous dispersion of the polymer obtained by an emulsion polymerization method. The composition of the polymer is a tetrafluoroethylene (TFE) homopolymer or a copolymer (modified PTFE) comprising TFE and a small amount, generally 0.5 weight% or less of perfluoroalkylvinylether, hexafluoropropylene or the like.

In this process, it is preferable that the orientation of PTFE is inhibited as much as possible, since the following expanding process can proceed smoothly. The inhibition of the orientation can be achieved by appropriately selecting a reduction ratio (a preferable range is 100:1 or less, and normally 20 to 60:1), a proportion of PTFE/extrusion aid (normally 77/23 to 80/20), a die angle of the extruder (normally approximately 60°) and the like in the extrusion of the paste.

(2) Rolling process of the paste extrudate

The paste extrudate obtained in the process (1) is rolled in the extrusion direction or the orthogonal direction of the extrusion direction with a calendar roll or the like to be made into a sheet form.

(3) Removing process of the extrusion aid

The extrusion aid is removed by heating the rolled object obtained in the process (2) or by extraction using a solvent such as trichloroethane, trichloroethylene or the like.

Though the heating temperature can be selected as needed according to an extrusion aid, it is preferable that the temperature is 200 to 300°C. In particular, it is preferable to conduct the heating at approximately 250°C. When the temperature exceeds 300°C, especially 327°C which is the melting point of PTFE, the rolled object tends to be sintered.

(4) Expanding process

The rolled object without extrusion aids obtained in the process (3) is expanded in the uniaxial direction or biaxial directions. The rolled object can be preheated to approximately 300°C before the expanding. Additionally, when conducting a biaxial expanding, both of consecutive expanding and simultaneous expanding are possible.

The expanding ratio should be selected carefully, since it affects the tensile strength and the like of the film. The ratio is normally in the range between 300 to 1,000% in the area ratio, and preferably 400 to 800%. When the ratio is lower than 300%, a desired pore size and porosity tend not to be able to be obtained, and when the ratio is higher than 1,000%, a desired pore size and porosity also tend not to be able to be obtained.

(5) Heat-setting process

The expanded object obtained in the process (4) is heat-treated for a relatively short period of time (5 to 15 seconds) at 340 to 380°C, which is the temperature a little higher than the melting point of PTFE (approximately 327°C) and lower than the decomposition temperature thereof, to be heat-set. When the temperature is lower than 340°C, the setting is not enough, and when the temperature is higher than 380°C, the heat-setting time becomes short and the control of the time tends to be difficult.

In the present invention, an asymmetric porous PTFE film is produced by cooling one surface of the expanded porous PTFE film obtained in the above manner while heat-treating the other surface and subsequently cooling.

At this time, the heating condition is such that the expanded porous PTFE film is heat-treated at 260°C to 380°C, preferably 340°C to 360°C for 5 to 15 seconds, preferably 6 to 10 seconds. When the heat-treating temperature is lower than 260°C, the formation of the skin layer 1131 tends to become not enough. On the other hand, when the temperature exceeds 380°C, the thickness of the skin layer 1131 becomes excessive and sound transmission capability and air permeability tend to be reduced.

As described above, by heat-treating one surface of the heat-set symmetric porous PTFE film once again, only the one surface of the film is modified and an asymmetric porous PTFE film having a porous structure, an improved surface roughness and a large water contact angle and the like can be obtained.

Regarding the porous structure, according to SEM photograph, a conventional symmetric porous PTFE film wholly forms an approximately uniform porous structure. On the other hand, in the asymmetric porous PTFE film of the present invention, the skin layer 1131 is formed as a dense layer and the porous layer 1132 has the porous structure similar to that of the conventional symmetric porous PTFE film. Further, the porosity of the whole film is 5 to 90%, preferably 20 to 90%, and more preferably 50 to 90%. Considering that the porosity of the symmetric porous PTFE film is 45 to 90%, it is recognized that the film is considerably densified. When the porosity is less than 5%, an amount of air permeation is reduced and thereby the air permeability is weakened, while the water-proof property is reduced when the porosity exceeds 90%. Here, the porosity is obtained from the measurement of density, using the following formula:

$$\text{Porosity (\%)} = (1 - \text{PTFE apparent density} / \text{PTFE true density}) \times 100,$$

wherein the PTFE apparent density (g/cc) = weight (W) / volume (V) of the porous PTFE film, and the true density(g/cc) = 2.15 (literature data).

The pore size of the porous layer of the asymmetric porous PTFE film of the present invention is 0.01 to 15 $\mu$m, preferably 0.05 to 10 $\mu$m, and more preferably 0.2 to 3 $\mu$m. In the specification, the pore size is measured according to the method of ASTM F316. When the pore size is smaller than 0.01 $\mu$m, an amount of air permeation is reduced and thereby air permeability and sound transmission capability are reduced, while water-proof property is reduced when the pore size exceeds 15 $\mu$m. Moreover, it is preferable that the pore size of the porous layer 11.32 is 0.04 to 0.80 $\mu$m.

First, regarding the symmetric porous PTFE film and the asymmetric PTFE film obtained by heat-treating thereof, it is ensured from the SEM photographs ($\times$20000 magnification) that the pore sizes, the structures and the like of the porous layers before and after the heat treatment have not changed. One of characters of the present invention is that after the heat treatment, the pore size, structure and the like of the porous layer 1132 do not change but the skin layer 1131 is modified.

During the pressure of introduced air being low, a sample film becomes a barrier and the pressure inside a chamber gradually increases. When the pressure becomes high and the barrier property of the sample film is lost, permeation of the air starts and increase in the pressure of the test chamber stops, and thus the pressure thereof is measured.

In addition, when preparing the asymmetric porous structure 113 of the present invention, other mixtures may be added. The additives to be mixed are titanium dioxide, silicon dioxide, carbon black, carbon nanotube, inorganic oxide and organic oxide. These additives may be used independently or may be used in combination of two or more thereof. The content of the additives is approximately 15 to 30%.

The asymmetric porous structure 113 used in the present invention has a thickness of, for example, 1 to 1,000 $\mu$m, preferably 5 to 500 $\mu$m, and more preferably 10 to 200 $\mu$m. When the thickness of the asymmetric porous structure 113 is less than 1 $\mu$m, the mechanical strength thereof is not enough and therefore lacks practicability. On the other hand, when the thickness of the asymmetric porous structure 113 is more than 1,000 $\mu$m, air permeability thereof decreases.

The asymmetric porous structure 113 used in the present invention has a Frazier air permeability of (10 to 60) $\times 10^4$ft$^3$/minft$^2$, preferably (25 to 45) $\times 10^4$ft$^3$/minft$^2$, and more preferably (30 to 45) $\times 10^4$ft$^3$/minft$^2$.

Measurement of Frazier air permeability

Frazier air permeability is measured according to ASTM D-726-58.

The asymmetric porous structure 113 used in the present invention having the following properties is obtained by treating a symmetric porous structure which has a Gurley number of 0.3 to 25 seconds, preferably 0.5 to 2.5 seconds, and more preferably 0.6 to 1.0 second under the above conditions. The Gurley number is measured according to the method of JIS P8117.

Further, when the skin layer 1131 is formed on the first surface of the continuously foamed porous layer 1132, it is preferable that the skin layer makes up 0.04 to 40% of the thickness of the asymmetric porous structure 113. By providing the skin layer 1131 in this proportion, the function of the water-proof and dust-proof membrane assembly 10 of the present invention can be achieved.

Moreover, in the water-proof and dust-proof membrane assembly 10 of the present invention, it is preferable that the water contact angle of the skin layer 1131 is 120° to 135°. When the water contact angle of the skin layer 1131 is within this range, the water-proof and dust-proof membrane assembly 10 of the present invention has enough water-proof property.

Here, the water contact angle is obtained by the following formula:

$$\text{Water contact angle} = 2\tan^{-1}(h/r),$$

wherein h = the height of spherical water droplet and r = the radius of the droplet.

The asymmetric porous structure 113 is produced by heat-treating a symmetric porous structure, and it is preferable that the Frazier air permeability after the heat treatment is 1.1 to 2.5 times that before the heat treatment, preferably 1.2 to 2.0, and more preferably 1.3 to 1.9. The water-proof and dust-proof membrane assembly 10 of the present invention increases air permeability by providing the skin layer 1131 on the symmetric porous structure 1132. From this, the water-proof and dust-proof membrane assembly 10 having enough air permeability can be obtained.

The sound transmission loss of the asymmetric porous structure 113 according to the water-proof and dust-proof membrane assembly 10 of the present invention is 0.5 to 2.5 dB, preferably 0.5 to 1.8 dB, and more preferably 0.5 to 1.3 dB. In this manner, the water-proof and dust-proof membrane assembly 10 of the present invention has high sound transmission capability while having high water-proof property. The sound transmission loss is measured according to the method of IEEE269.

When the skin layer 1131 is formed on the first surface of the asymmetric porous structure 113, water pressure resistance is 3,000 to 20,000 mmH$_2$O (= 29,400 to 196,000 Pa), preferably 8,000 to 19,000 mmH$_2$O (= 78,400 to 186,200 Pa), and more preferably 10,000 to 16,000 mmH$_2$O (= 98,000 to 156,800 Pa).

The collecting efficiency of the asymmetric porous structure 113 according to the water-proof and dust-proof membrane assembly 10 of the present invention is 99.50 to 99.99%, preferably 99.70 to 99.99%, and more preferably 99.90 to 99.99%. In this manner, since the collecting efficiency of the asymmetric porous structure 113 is extremely excellent, the water-proof and dust-proof membrane assembly 10 of the present invention has excellent dust-proof property. The collecting efficiency is calculated by the following formula by setting the porous PTFE film to a filter holder MODEL8130 (manufactured by TSI), regulating an air flow rate on the outlet side to 35.9 L/min with a pressure regulation, filtering the air including colloid particles having a particle size of 0.3 μm, and then measuring the number of permeated particles with a particle measuring machine.

$$\text{Collecting efficiency (\%)} = [1 - (\text{permeated particle concentration at the downstream side}) / (\text{particle concentration in the air at the upstream side})] \times 100$$

As described above, the asymmetric porous structure 113 configuring the body of the present invention has heat resistance, flame resistance, acid resistance, alkali resistance, water-proof property, water repellency and oil repellency. Further, combined intersections of the mesh of the asymmetric porous structure 113 exist in all directions. Therefore, the body hardly causes creep.

Furthermore, the asymmetric porous structure 113 of the body 11 can satisfy a water-proof property, dust-proof property, sound transmission capability and air permeability required for individual products, by regulating the pore size and first porosity thereof. For example, when the PTFE film is manufactured by the above expansion forming method, the pore size is controlled by controlling the expanding temperature, expanding speed and the like, and then the first porosity and the uniformity of the asymmetric porous structure are improved by a densifing process.

[Supporting member]

In the water-proof and dust-proof membrane assembly 10 of the present invention, the supporting member 12 is formed with a polymeric material. Material of the supporting member 12 is not limited specifically, and for example, a polyester resin, a polyethylene resin, an aromatic polyamide resin and the like can be exemplified. The supporting member 12 may be a woven fabric, a nonwoven fabric, a mesh, a net, a sponge form, a foam, a porous body and the like.
Moreover, the supporting member 12 is porous, and the porosity of the supporting member 12 (second porosity) is larger than the first porosity, i.e. 10% to 99.9%. By using such a supporting member, functions such as water-proof property, dust-proof property, sound transmission capability and air permeability are hardly decreased even the body 11 and the supporting member 12 are bonded. Further, supporting strength and water pressure resistance are enhanced by bonding the supporting member 12 to the body 11.
The water-proof and dust-proof membrane assembly 10 of the present invention is obtained by bonding the body 11 and the supporting member 12. Specifically, the first surface 111 of the body 11 and the first contact surface 121 of the supporting member 12 are bonded to each other. The method of bonding between the body 11 and the supporting member 12 is not limited and the bonding can be carried out by using an adhesive, double-faced adhesive tape and the like or by thermocompression bonding or ultrasonic bonding,. A preferable bonding method is thermocompression bonding, since the effect of supporting strength and water pressure resistance can be ensured with few loss of the body function.
In the example of Fig. 1, the skin layer 1131 is provided on the first surface 111 side of the body. According to this embodiment, enough air permeability is obtained and thereby formation of dew inside the apparatus can be effectively prevented.
The water-proof and dust-proof membrane assembly of the present invention can be an optional shape, depending on an applied product. For example, the assembly may be circular, elliptical, polygonal, an indeterminate form and the like.
The water-proof and dust-proof membrane assembly 10 of the present invention may be dyed, depending on applied products or a color of applied products. Either the body 11 or the supporting member 12, or both of them may be dyed. The dyeing may be carried out during or after producing the body 11 and the supporting member 12, and the dyeing after bonding the both is also possible. Colors to be dyed are not limited specifically and can be selected appropriately according to applied products or the color of applied products. The method of dyeing can be selected from known methods, and an example thereof is an immersion in a solution in which a dye has been dissolved.
Further, the water-proof and dust-proof membrane assembly 10 of the present invention can undergo an oil repellent process. By conducting an oil repellent process, oil repellency can be improved. For an oil repellent process, known fluorine-containing oil repellent agents or silicone based oil repellent agents can be used. Oil resistance level of the water-proof and dust-proof membrane assembly 10 of the present invention is thereby improved and the water-proof and dust-proof membrane assembly 10 can be used even under a specific operation environment. Either the body 11 or the supporting member 12, or the both of them can undergo the oil repellent process. The oil repellent process may be carried out during or after producing the body 11 and the supporting member 12, and the oil repellent process after bonding the both is also possible. The oil repellent process is carried out by applying and impregnating a known oil repellent agent and the evaluation of oil repellency is conducted according to AATCC 188.

[Embodiment 2]

Fig. 2 shows the water-proof and dust-proof membrane assembly of the embodiment 2 of the present invention. Reference numerals of Fig. 2 are the same as those of Fig. 1. The water-proof and dust-proof membrane assembly 10 of an example of Fig. 2 is the same as the water-proof and dust-proof membrane assembly of the embodiment 1, except that the skin layer 1131 is provided at the second surface 112 side differently from the water-proof and dust-proof membrane assembly of Fig. 1 where the skin layer 1131 is provided on the first surface 111 side.
In the water-proof and dust-proof membrane assembly 10 of an example of Fig. 2, the skin layer 1131 is provided at the second surface 112 side of the body 11. As a result, when the same body 11 is used, air permeation is decreased more than the embodiment 1 while water pressure resistance and sound transmission loss increase more than the embodiment 1. The water-proof and dust-proof membrane assembly 10 of an example of Fig. 2 is therefore preferably used underwater, for example, for an underwater camera. In addition, by modifying the configuration of the body, air permeability and the like can be improved. For this reason, the water-proof and dust-proof membrane assembly of an example of Fig. 2 has the same functions as those of the water-proof and dust-proof membrane assembly of an example of Fig. 1.

[Embodiment 3]

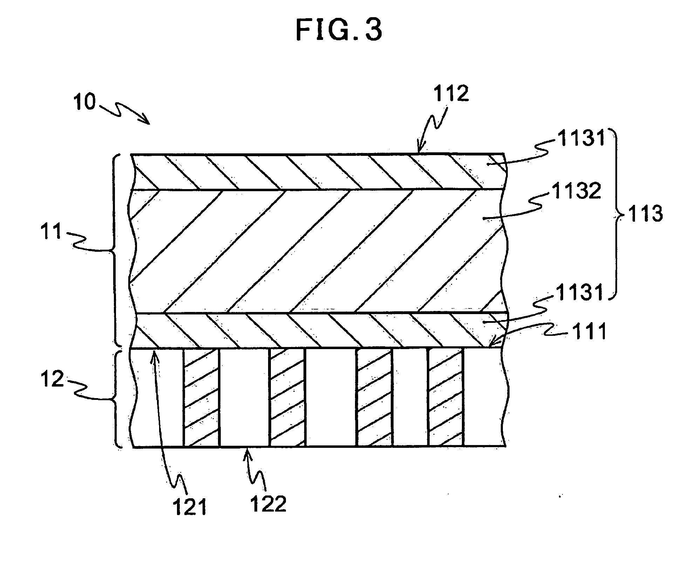

Fig. 3 shows the water-proof and dust-proof membrane assembly of the embodiment 3 of the present invention. Reference numerals of Fig. 3 are the same as those of Fig. 1. The water-proof and dust-proof membrane assembly of an example of Fig. 3 is the same as the water-proof and dust-proof membrane assembly of the embodiment 1, except that the skin layers 1131 are provided on both of the first surface 111 side and the second surface 112 side.

With the configuration of Fig. 3, water pressure resistance can be improved, and the other functions and effects thereof are the same as those of Fig. 1. This is because the pore size of the body composing the water-proof and dust-proof membrane assembly of the present invention is far greater than a size of the air molecules (up to 0.0004 $\mu$m). Moreover, since the skin layer 1131 is also provided at the second surface 112 side, water pressure resistance can be improved similarly to the embodiment 2.

Water pressure resistance in this embodiment is 5,000 to 20,000 mmH$_2$O (= 49,000 to 196,000 Pa), preferably 11,000 to 19,000 mmH$_2$O (= 107,800 to 186,200 Pa), and more preferably 13,000 to 16,000 mmH$_2$O (= 127,400 to 156,800 Pa). Therefore the asymmetric porous structure in the form of membrane that is the body can be changed according to a demand for water pressure resistance of a product using the water-proof and dust-proof membrane assembly of the present invention.

The skin layer 1131 may be formed on the both sides of the first surface 111 and the second surface 112 of the porous layer 1132 by the following method.

First of all, a porous structure 13 is expanded in the machine direction (MD). It is preferable that the expanding ratio is 3 to 30, preferably 5 to 20 and more preferably 10 to 50, and that the expanding temperature is 200 to 400°C, preferably 250 to 350°C and more preferably 280 to 330°C. Here, the expanding ratio of 3 means that the porous structure having the length of 1 is expanded threefold (1:3).

Then the porous structure 13 which underwent the expanding in the machine direction (MD) is expanded in the transverse direction (TD). It is preferable that the expanding ratio is 2 to 20, preferably 3 to 15 and more preferably 3 to 12, and that the expanding temperature is 200 to 400°C, preferably 250 to 350°C and more preferably 280 to 330°C.

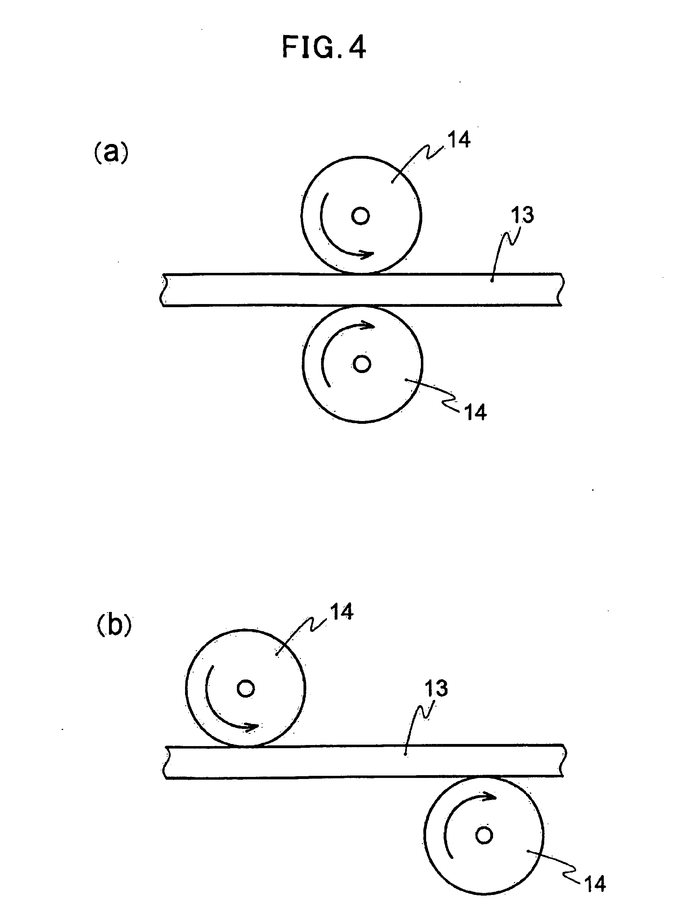

The uniform symmetric porous structure 13 is firstly heated and densified using heated rollers 14 to form a skin layer 1131. The heating process is, as shown in Fig. 4 (a), conducted by sandwiching the uniform symmetric porous structure 13 with heating rollers from above and below, and moving the rollers in the same direction. Alternatively, as shown in Fig. 4 (b), it is also possible to treat one surface of the uniform symmetric porous structure 13 with the heated roller 14 to densify it and then treat the other surface with another heated roller 14 to densify it. In addition, when treating the both surfaces of the uniform symmetric porous structure 13 separately with a heated roller, the method is not limited to the example of Fig. 4 (b) and it is also possible to conduct a heat treatment with one heated roller 14, by changing the direction of movement of the film with the roller or the like. In this manner, the skin layer 1131 is formed by heating. The temperature of the heated rollers 14 is, for example, 100 to 400°C. When the heating process is conducted by sandwiching the uniform symmetric porous structure 13 with heating rollers from above and below, low temperature (for example, 250 to 300°C) is preferable and when the skin layer 1131 is formed by heating above and below thereof separately, high temperature (for example, 350 to 400°C) is preferable. It is more preferable to form a skin layer 1131 by hating above and below separately, since the film is hardly affected by pressurization of a roller.

Then, the heated and densified expanded porous PTFE film undergoes a second expanding process in a transverse direction. In the second expanding in a transverse direction (TD), it is preferable that the expanding ratio is 1.5 to 10, preferably 2 to 6 and more preferably 3 to 6, and that the expanding temperature is 200 to 400°C, preferably 250 to 350°C and more preferably 280 to 330°C.

After the expanding process, a heating process using heated rollers 14 is further conducted. The temperature of the heated rollers 14 is, for example, 100 to 400°C, and the method of the heating process is similar to that described above.

Here, the second expanding in a transverse direction and the heating process thereafter can be omitted.

As described above, the water-proof and dust-proof membrane assembly 10 of the present invention is excellent in water-proof property, dust-proof property, air permeability and water pressure resistance. Therefore the water-proof and dust-proof membrane assembly 10 of the present invention can be widely used in general electronic products, underwater electronic products and other products.

Examples of a general electronic product are digital camera, cell phone, MP3 player, earphone, microphone, speaker, radio, digital book, automobile backup radar, transceiver, projector, ink cartridge, battery box, outdoor lighting equipment, automobile lamp, LED lighting device, gas detector, medical electronic product, military-specific electronic product and the like.

Examples of an underwater electronic product are products where relatively high water-proof standards are required, such as underwater digital video camera, underwater digital camera, underwater MP3 player, underwater lighting apparatus, water-proof adapter and the like.

Moreover, the water-proof and dust-proof membrane assembly 10 of the present invention can be also applied to a water-proof and dust-proof vented container requiring a specific condition or other products such as can packaging container (for example, Petri dish, solar cell junction box and container etc.).

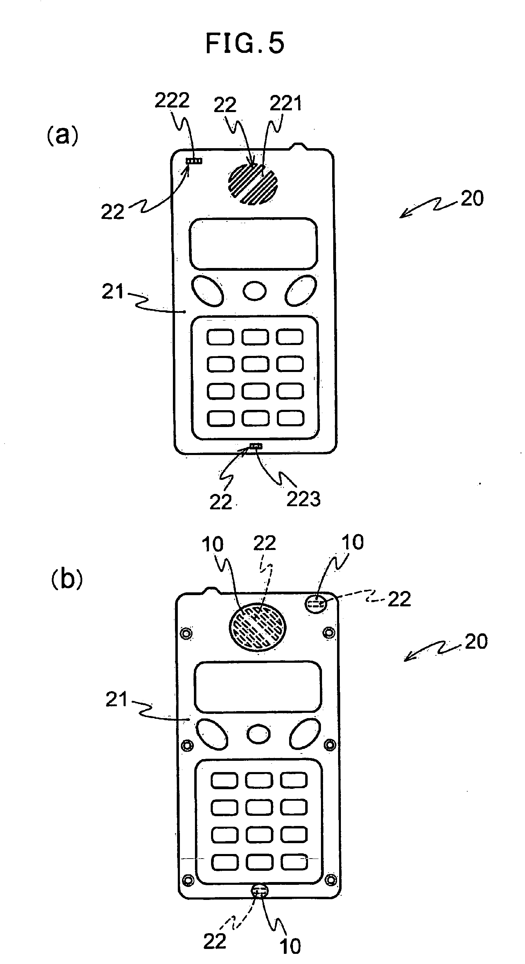

Fig. 5 is a schematic view of a cell phone using the water-proof and dust-proof membrane assembly 10 of the present invention. As shown in Fig. 5 (a), the cell phone 20 has a housing 21 and at least one electronic circuit component (not shown). In the front surface of the housing, at least one opening 22 (three openings in the example of this figure) is provided. Each opening 22 is provided with a transceiver 221, a speaker 222 and a microphone 223. Further, Fig. 5 (b) is a view showing the inside of the housing 21 of the cell phone shown in Fig. 5 (a). As shown in Fig. 5 (b), the water-proof and dust-proof membrane assembly 10 of the present invention is located at each opening 22 by being fitted. In this manner, it is possible to prevent moisture, salt content or other liquid from intruding into a product via the openings 22, by locating the water-proof and dust-proof membrane assembly 10 fitted for the openings 22. As a result, the electronic circuit component inside the housing can be protected and thereby the service life of cell phone can be improved. The similar effect can be exhibited also in other electronic devices.

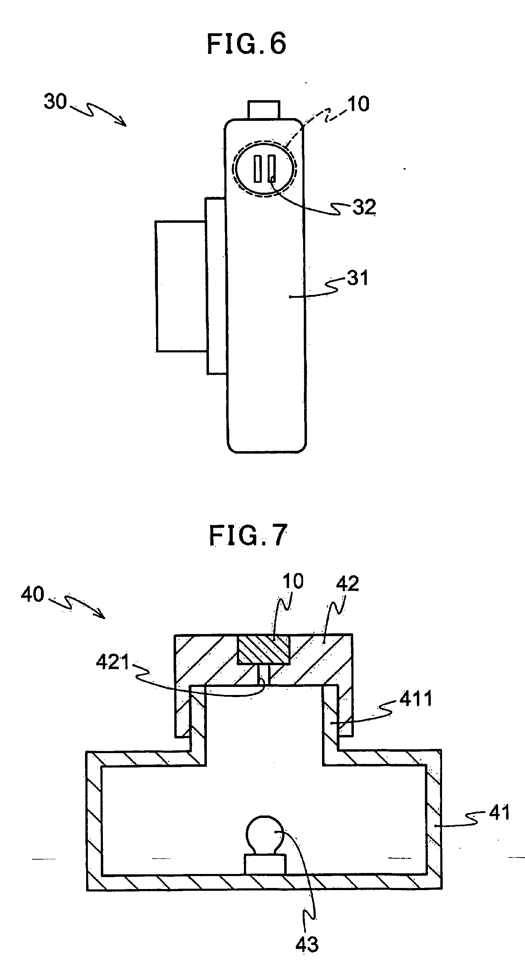

Fig. 6 is a schematic view of an underwater digital camera 30 using the water-proof and dust-proof membrane assembly 10 of the present invention. As shown in Fig. 6, the underwater digital camera 30 has a housing 31 and at least one electronic circuit component (not shown). In the front surface of the housing 31, at least one opening 32 (one opening in the example of this figure) is provided. This opening 32 is used as a sound transmitter or a microphone at video recording. For the underwater digital camera 30, quality of sound transmitted at video recording is as important as the water-proof function. In the example of Fig. 6, the water-proof and dust-proof membrane assembly 10 of the present invention which is fitted for the opening 32 is located in the housing. In this manner, it is possible to prevent liquid such as water from intruding into a product via the openings 32, by locating the water-proof and dust-proof membrane assembly 10 fitted for the openings 32. On the other hand, the water-proof and dust-proof membrane assembly 10 of the present invention is excellent in sound transmitting capability and water pressure resistance. As a result, the electronic circuit component inside the housing can be protected even if the camera is used underwater and thereby the service life of the underwater digital camera can be improved while its sound transmitting capability is excellent.

Fig. 7 is a schematic view of a lighting system using the water-proof and dust-proof membrane assembly 10 of the present invention. As shown in Fig. 7, the lighting system 40 has a hollow housing 41, a cover 42 and at least one light source device (for example, light emitting diode) 43. The hollow housing 41 has a window portion 411 which mates with the cover 42. The cover 42 has at least one opening 421. The at least one light source device 43 is located inside the housing 41, being fitted for the at least one opening 421. The water-proof and dust-proof membrane assembly 10 of the present invention is located over the at least one opening 421. Since the water-proof and dust-proof membrane assembly 10 of the present invention has excellent water-proof property, dust-proof property and air permeability, moisture has free access to inside the lighting system 40 via the opening 421 of the cover 42. As a result, dew inside the hollow housing 41 of the lighting system can be rapidly removed and reduced. At the same time, intrusion of exterior dust or rain water into the system can be prevented.

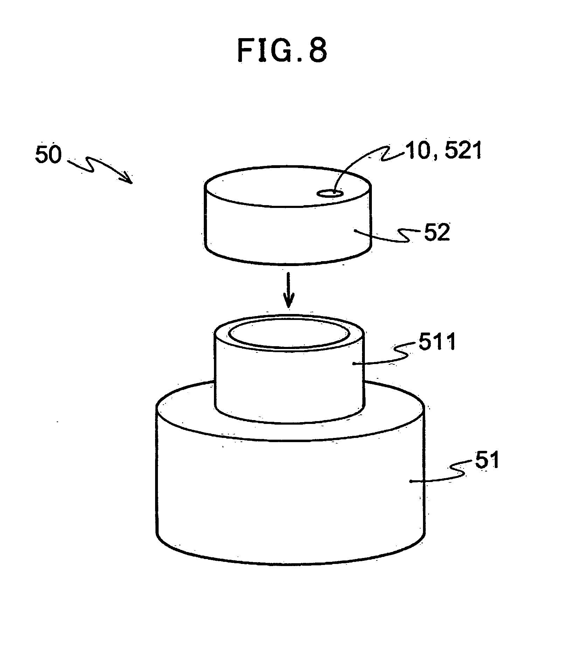

Fig. 8 is a schematic view of a container using the water-proof and dust-proof membrane assembly 10 of the present invention. As shown in Fig. 8, the container 50 has a hollow housing 51 and a cap 52. The hollow housing 51 has a window portion 511 which mates with the cap 52. The cap 52 has at least one opening 521. The water-proof and dust-proof membrane assembly 10 of the present invention is located over the opening 521 provided in the cap 52. Since the water-proof and dust-proof membrane assembly 10 of the present invention has excellent water-proof property, dust-proof property and air permeability, moisture has free access to inside the cap 50 via the opening 521 of the cap 52. As a result, dew inside the hollow housing 51 of the container 50 can be rapidly removed and reduced, and thereby the inside of the container 50 can be protected from moisture.

Hereinafter, the present invention will be explained based on Examples, but the present invention is not limited thereto.

EXAMPLE

(Example A)

The water-proof and dust-proof membrane assembly 10 of the present invention in which the skin layer 1131 is provided on the first surface 111 side of the body 11 as shown in Fig. 1 was used.

(Example B)

The water-proof and dust-proof membrane assembly of the present invention in which the skin layer 1131 is provided on the second surface 112 side of the body 11 as shown in Fig. 2 was used.

Gurley number, air permeability, water pressure resistance and sound transmission loss of the above Examples A and B were examined and the results are shown in the following Table. The following value is the average value of the measurements of 10 assemblies.

[Table 1]

|  | Example A | Example B |
|---|---|---|
| Gurley number (second/100 ml) | 0.25 to 0.28 | 14.7 to 15.2 |
| Air permeability ($cm^3/cm^2$/second) | 4.3 to 4.5 | 0.27 to 0.29 |
| Water pressure resistance ($mmH_2O$) | 2,600 to 2,800 | 10,500 to 11,500 |
| Sound transmission loss (dB) | less than 2.5 | less than 1.0 |

From this Table, it is noticed that when the same asymmetric porous structure is used, the one having the skin layer on the first surface side has smaller Gurley number and larger air permeability. Therefore it is notified that the structure of embodiment 1 is more preferable when used for preventing dew formation of non-electronic components.
On the other hand, it is noticed that the one having the skin layer on the second surface side has smaller air permeability while having larger water pressure resistance and smaller sound transmission loss. Therefore it is noticed that the structure of embodiment 2 is more preferable when used for preventing dew formation of non-electronic components and more suitable for underwater electronic devices and the like.

(Example 2-1)

One surface of a symmetric porous structure having a porosity of 60%, a thickness of 20 to 25 $\mu$m and a pore size of 0.20 to 0.45 $\mu$m was cooled while the other surface was heated as shown in the following Table. The results are shown in Table 2.

[Table 2]

| Heat treatment temperature (°C) | unheated | 260 | 300 | 340 | 380 | 400 |
|---|---|---|---|---|---|---|
| Thickness of film ($\mu$m) | 22 | 21 | 23 | 20 | 23 | 16 |
| Porosity (%) | 60 | 60 | 62 | 63 | 61 | 48 |
| Pore size ($\mu$m) | 0.20 to 0.45 | 0.16 to 0.45 | 0.11 to 0.45 | 0.04 to 0.45 | 0.03 to 0.45 | 0.03 to 0.25 |
| Water contact angle (°) | 117 | 118 | 130 | 133 | 129 | 113 |
| Frazier air permeability ($\times 10^4 ft^3$/minft$^2$) | 15.1 | 17.5 | 24.5 | 24.5 | 22.9 | 7.4 |
| Frazier air permeability index | 1 | 1.159 | 1.397 | 1.623 | 1.516 | 0.49 |
| Collecting efficiency (%) | 99.21 | 99.64 | 99.92 | 99.99 | 99.99 | 99.99 |
| Water pressure resistance ($mmH_2O$) | 7,000 | 9,000 | >10,000 | >10,000 | >15,000 | >15,000 |
| Gurley number (second) | 6.6 | 6.5 | 6.3 | 6.1 | 6.4 | 27.3 |
| Sound transmission loss (dB) | 1.2 | 1.2 | 1.3 | 1.5 | 1.7 | 1.9 |

From Table 2, it is noticed that the asymmetric porous structure which is excellent in water-proof property, dust-proof property, sound transmission capability and air permeability can be obtained when heated at especially 300 to 380°C.

(Example 2-2)

One surface of a symmetric porous structure having a porosity of 70%, a thickness of 20 to 25 $\mu$m and a pore size of 0.20 to 0.45 $\mu$m was cooled while the other surface was heated as shown in the following Table. The results are shown in Table 3.

[Table 3]

| Heat treatment temperature (°C) | unheated | 260 | 300 | 340 | 380 | 400 |
|---|---|---|---|---|---|---|
| Thickness of film (ym) | 21 | 22 | 21 | 21 | 23 | 18 |
| Porosity (%) | 70 | 70 | 71 | 72 | 70 | 59 |
| Pore size ($\mu$m) | 0.21 to 0.45 | 0.19 to 0.45 | 0.10 to 0.45 | 0.03 to 0.45 | 0.03 to 0.45 | 0.03 to 0.27 |
| Water contact angle (°) | 116 | 120 | 127 | 130 | 129 | 115 |
| Frazier air permeability ($\times 10^4$ft$^3$/minft$^2$) | 17.2 | 18.6 | 27.6 | 32.5 | 31.1 | 7.8 |
| Frazier air permeability index | 1 | 1.081 | 1.424 | 1.773 | 1.575 | 0.47 |
| Collecting efficiency (%) | 99.28 | 99.59 | 99.94 | 99.99 | 99.99 | 99.99 |
| Water pressure resistance (mmH$_2$O) | 6,500 | 8,600 | >10,000 | >10,000 | >15,000 | >15,000 |
| Gurley number (second) | 5.9 | 5.6 | 5.3 | 5.1 | 5.6 | 26.4 |
| Sound transmission loss (dB) | 1.1 | 1.1 | 1.2 | 1.3 | 1.6 | 1.9 |

From Table 3, it is noticed that the asymmetric porous structure which is excellent in water-proof property, dust-proof property, sound transmission capability and air permeability can be obtained when heated at especially 300 to 380°C.

(Example 2-3)

One surface of a symmetric porous structure having a porosity of 80%, a thickness of 20 to 25 $\mu$m and a pore size of 0.20 to 0.45 $\mu$m was cooled while the other surface was heated as shown in the following Table. The results are shown in Table 4.

[Table 4]

| Heat treatment temperature (°C) | unheated | 260 | 300 | 340 | 380 | 400 |
|---|---|---|---|---|---|---|
| Thickness of film ($\mu$m) | 22 | 21 | 21 | 20 | 23 | 15 |
| Porosity (%) | 81 | 80 | 80 | 82 | 79 | 71 |
| Pore size ($\mu$m) | 0.20 to 0.45 | 0.19 to 0.45 | 0.09 to 0.45 | 0.03 to 0.45 | 0.03 to 0.45 | 0.02 to 0.28 |
| Water contact angle (°) | 118 | 122 | 129 | 131 | 132 | 116 |
| Frazier air permeability ($\times 10^4$ft$^3$/minft$^2$) | 17.3 | 19.2 | 27.6 | 32.5 | 31.1 | 7.8 |

(continued)

| Heat treatment temperature (°C) | unheated | 260 | 300 | 340 | 380 | 400 |
|---|---|---|---|---|---|---|
| Frazier air permeability index | 1 | 1.109 | 1.595 | 1.878 | 1.797 | 0.45 |
| Collecting efficiency (%) | 99.35 | 99.61 | 99.97 | 99.99 | 99.99 | 99.99 |
| Water pressure resistance (mmH$_2$O) | 6,000 | 8,400 | >10,000 | >10,000 | >15,000 | >15,00 0 |
| Gurley number (second) | 4.9 | 4.8 | 4.7 | 4.2 | 4.8 | 24.9 |
| Sound transmission loss (dB) | 1 | 1 | 1.1 | 1.1 | 1.5 | 1.9 |

From Table 4, it is noticed that the asymmetric porous structure which is excellent in water-proof property, dust-proof property, sound transmission capability and air permeability can be obtained when heated at 260 to 380°C, especially 300 to 380°C.

(Example 2-4)

One surface of a symmetric porous structure having a porosity of 90%, a thickness of 20 to 25 $\mu$m and a pore size of 0.20 to 0.45 $\mu$m was cooled while the other surface was heated as shown in the following Table. The results are shown in Table 5.

[Table 5]

| Heat treatment temperature (°C) | unheated | 260 | 300 | 340 | 380 | 400 |
|---|---|---|---|---|---|---|
| Thickness of film ($\mu$m) | 22 | 23 | 20 | 19 | 22 | 16 |
| Porosity (%) | 86 | 86 | 86 | 87 | 86 | 75 |
| Pore size ($\mu$m) | 0.20 to 0.45 | 0.17 to 0.45 | 0.08 to 0.45 | 0.03 to 0.45 | 0.03 to 0.45 | 0.02 to 0.29 |
| Water contact angle (°) | 119 | 122 | 131 | 135 | 132 | 117 |
| Frazier air permeability ($\times 10^4$ft$^3$/minft$^2$) | 19.5 | 21.1 | 30.5 | 34.5 | 32.8 | 8.6 |
| Frazier air permeability index | 1 | 1.082 | 1.561 | 1.769 | 1.682 | 0.441 |
| Collecting efficiency (%) | 99.51 | 99.89 | 99.98 | 99.99 | 99.99 | 99.99 |
| Water pressure resistance (mmH$_2$O) | 5,500 | 8,500 | >10,00 0 | >10,000 | >15,000 | >15,000 |
| Gurley number (second) | 3.9 | 3.8 | 3.2 | 2.9 | 3.5 | 23.1 |
| Sound transmission loss (dB) | 0.8 | 0.9 | 1 | 1 | 1.3 | 1.8 |

From Table 5, it is noticed that the asymmetric porous structure which is excellent in water-proof property, dust-proof property, sound transmission capability and air permeability can be obtained when heated at 260 to 380°C, especially 300 to 340°C.

(Example 2-4)

One surface of a symmetric porous structure having a porosity of 60%, a thickness of 10 $\mu$m or less and a pore size of 0.7 to 1.3 $\mu$m was cooled while the other surface was heated as shown in the following Table. The results are shown in Table 6.

[Table 6]

| Heat treatment temperature (°C) | unheated | 260 | 300 | 340 | 380 | 400 |
|---|---|---|---|---|---|---|
| Thickness of film ($\mu$m) | 10 | 9 | 10 | 9 | 8 | 8 |
| Porosity (%) | 60 | 60 | 62 | 63 | 61 | 48 |
| Pore size ($\mu$m) | 0.70 to 1.3 | 0.31 to 1.3 | 0.13 to 1.3 | 0.09 to 1.2 | 0.08 to 0.68 | 0.06 to 0.31 |
| Water contact angle (°) | 110 | 115 | 121 | 129 | 127 | 114 |
| Frazier air permeability ($\times 10^4 ft^3$ /minft$^2$) | 27.5 | 30.9 | 37.3 | 43.2 | 35.8 | 11.9 |
| Frazier air permeability index | 1 | 1.123 | 1.356 | 1.57 | 1.301 | 0.432 |
| Collecting efficiency (%) | 99.29 | 99.88 | 99.97 | 99.99 | 99.99 | 99.99 |
| Water pressure resistance (mmH$_2$O) | 3,500 | 6,000 | 8,600 | >10,000 | >10,000 | >10,000 |
| Gurley number (second) | 1 | 1 | 0.9 | 0.8 | 1 | 16.9 |
| Sound transmission loss (dB) | 0.6 | 0.6 | 0.6 | 0.6 | 0.7 | 1.4 |

From Table 6, it is noticed that the asymmetric porous structure which is excellent in water-proof property, dust-proof property, sound transmission capability and air permeability can be obtained when heated at 260 to 380°C, especially 300 to 380°C.

(Example 2-6)

One surface of a symmetric porous structure having a porosity of 70%, a thickness of 10 $\mu$m or less and a pore size of 0.7 to 1.3 $\mu$m was cooled while the other surface was heated as shown in the following Table. The results are shown in Table 7.

[Table 7]

| Heat treatment temperature (°C) | unheated | 260 | 300 | 340 | 380 | 400 |
|---|---|---|---|---|---|---|
| Thickness of film ($\mu$m) | 11 | 9 | 9 | 9 | 8 | 8 |
| Porosity (%) | 71 | 71 | 73 | 71 | 72 | 71 |
| Pore size ($\mu$m) | 0.70 to 1.3 | 0.32 to 1.3 | 0.12 to 1.3 | 0.09 to 1.2 | 0.08 to 0.99 | 0.05 to 0.35 |
| Water contact angle (°) | 113 | 120 | 124 | 129 | 124 | 114 |
| Frazier air permeability ($\times 10^4 ft^3$/minft$^2$) | 29.1 | 32.8 | 39.3 | 46.8 | 37.1 | 12.5 |
| Frazier air permeability index | 1 | 1.127 | 1.35 | 1.608 | 1.274 | 0.429 |
| Collecting efficiency (%) | 99.31 | 99.79 | 99.98 | 99.99 | 99.99 | 99.99 |
| Water pressure resistance (mmH$_2$O) | 2,500 | 5,800 | 8,500 | >10,000 | >10,000 | >10,000 |

(continued)

| Heat treatment temperature (°C) | unheated | 260 | 300 | 340 | 380 | 400 |
|---|---|---|---|---|---|---|
| Gurley number (second) | 0.9 | 0.9 | 0.8 | 0.6 | 9 | 15.6 |
| Sound transmission loss (dB) | 0.6 | 0.6 | 0.6 | 0.6 | 0.7 | 1.3 |

From Table 7, it is noticed that the asymmetric porous structure which is excellent in water-proof property, dust-proof property, sound transmission capability and air permeability can be obtained when heated at 260 to 380°C, especially 300 to 380°C.

(Example 2-7)

One surface of a symmetric porous structure having a porosity of 80%, a thickness of 10 $\mu$m or less and a pore size of 0.7 to 1.3 $\mu$m was cooled while the other surface was heated as shown in the following Table. The results are shown in Table 8.

[Table 8]

| Heat treatment temperature (°C) | unheated | 260 | 300 | 340 | 380 | 400 |
|---|---|---|---|---|---|---|
| Thickness of film ($\mu$m) | 10 | 9 | 10 | 10 | 9 | 8 |
| Porosity (%) | 80 | 83 | 82 | 83 | 81 | 82 |
| Pore size ($\mu$m) | 0.71 to 1.3 | 0.31 to 1.3 | 0.11 to 1.3 | 0.09 to 1.3 | 0.09 to 0.91 | 0.05 to 0.37 |
| Water contact angle (°) | 114 | 121 | 125 | 130 | 126 | 116 |
| Frazier air permeability ($\times 10^4 \mathrm{ft}^3/\mathrm{minft}^2$) | 31.2 | 35.1 | 42.6 | 48.9 | 38.7 | 13.4 |
| Frazier air permeability index | 1 | 1.125 | 1.365 | 1.567 | 1.24 | 0.429 |
| Collecting efficiency (%) | 99.35 | 99.81 | 99.98 | 99.99 | 99.99 | 99.99 |
| Water pressure resistance ($\mathrm{mmH_2O}$) | 1,500 | 5,500 | 8,400 | >10,000 | >10,000 | >10,000 |
| Gurley number (second) | 0.7 | 0.7 | 0.6 | 0.5 | 0.7 | 14.4 |
| Sound transmission loss (dB) | 0.5 | 0.5 | 0.5 | 0.5 | 0.6 | 1.2 |

From Table 8, it is noticed that the asymmetric porous structure which is excellent in water-proof property, dust-proof property, sound transmission capability and air permeability can be obtained when heated at 260 to 380°C, especially 340 to 380°C.

(Example 2-8)

One surface of a symmetric porous structure having a porosity of 90%, a thickness of 10 $\mu$m or less and a pore size of 0.7 to 1.3 $\mu$m was cooled while the other surface was heated as shown in the following Table. The results are shown in Table 9.

[Table 9]

| Heat treatment temperature (°C) | unheated | 260 | 300 | 340 | 380 | 400 |
|---|---|---|---|---|---|---|
| Thickness of film ($\mu$m) | 11 | 10 | 10 | 9 | 8 | 8 |

(continued)

| Heat treatment temperature (°C) | unheated | 260 | 300 | 340 | 380 | 400 |
|---|---|---|---|---|---|---|
| Porosity (%) | 90 | 92 | 90 | 91 | 89 | 91 |
| Pore size ($\mu$m) | 0.72 to 1.3 | 0.32 to 1.3 | 0.12 to 1.3 | 0.09 to 1.3 | 0.09 to 0.98 | 0.05 to 0.35 |
| Water contact angle (°) | 111 | 118 | 128 | 131 | 129 | 117 |
| Frazier air permeability ($\times 10^4 ft^3/minft^2$) | 33.1 | 38.4 | 45.3 | 51.9 | 40.9 | 15.7 |
| Frazier air permeability index | 1 | 1.16 | 1.368 | 1.567 | 1.235 | 0.474 |
| Collecting efficiency (%) | 99.49 | 99.88 | 99.98 | 99.99 | 99.99 | 99.99 |
| Water pressure resistance ($mmH_2O$) | 1,000 | 5,600 | 8,300 | > 10,000 | > 10,000 | > 10,000 |
| Gurley number (second) | 0.5 | 0.5 | 0.4 | 0.3 | 0.4 | 13.7 |
| Sound transmission loss (dB) | 0.5 | 0.5 | 0.5 | 0.5 | 0.6 | 1.1 |

From Table 9, it is noticed that the asymmetric porous structure which is excellent in water-proof property, dust-proof property, sound transmission capability and air permeability can be obtained when heated at 260 to 380°C, especially 340 to 380°C.

(Comparative Example 2-1)

One surface of a symmetric porous structure having a porosity of 60%, a thickness of 50 $\mu$m and a pore size of 0.05 to 0.08 $\mu$m was cooled while the other surface was heated as shown in the following Table. The results are shown in Table 10.

[Table 10]

| Heat treatment temperature (°C) | unheated | 260 | 300 | 340 | 380 | 400 |
|---|---|---|---|---|---|---|
| Thickness of film ($\mu$m) | 50 | 50 | 52 | 53 | 52 | 38 |
| Porosity (%) | 60 | 61 | 62 | 64 | 63 | 39 |
| Pore size ($\mu$m) | 0.05 to 0.08 | 0.05 to 0.08 | 0.03 to 0.08 | 0.02 to 0.08 | 0.01 to 0.08 | 0.01 to 0.04 |
| Water contact angle (°) | 117 | 118 | 125 | 129 | 128 | 113 |
| Frazier air permeability ($\times 10^4 ft^3/minft^2$) | 9.8 | 10.5 | 8.9 | 9.5 | 10.1 | 6.2 |
| Frazier air permeability index | 1 | 1.071 | 0.908 | 0.969 | 1.031 | 0.633 |
| Collecting efficiency (%) | 99.19 | 99.68 | 99.98 | 99.99 | 99.99 | 99.99 |
| Water pressure resistance ($mmH_2O$) | 150.1 | 150.5 | 150.7 | 151.1 | 151.1 | 163.5 |

From Table 10, it is noticed that the structure has less water-proof property and air permeability, since its pore size is too small.

(Comparative Example 2-2)

One surface of a symmetric porous structure having a porosity of 70%, a thickness of 50 $\mu$m and a pore size of 0.05 to 0.08 $\mu$m was cooled while the other surface was heated as shown in the following Table. The results are shown in Table 11.

[Table 11]

| Heat treatment temperature (°C) | unheated | 260 | 300 | 340 | 380 | 400 |
|---|---|---|---|---|---|---|
| Thickness of film ($\mu$m) | 49 | 49 | 50 | 51 | 51 | 41 |
| Porosity (%) | 70 | 70 | 70 | 72 | 71 | 52 |
| Pore size ($\mu$m) | 0.05 to 0.08 | 0.05 to 0.08 | 0.03 to 0.08 | 0.02 to 0.08 | 0.01 to 0.08 | 0.01 to 0.05 |
| Water contact angle (°) | 117 | 120 | 121 | 128 | 127 | 116 |
| Frazier air permeability ($\times 10^4 ft^3$/minft$^2$) | 9.8 | 10.5 | 9.1 | 9.9 | 10.2 | 6.9 |
| Frazier air permeability index | 1 | 1.071 | 0.929 | 1.01 | 1.041 | 0.704 |
| Collecting efficiency (%) | 99.24 | 99.49 | 99.94 | 99.99 | 99.99 | 99.99 |
| Water pressure resistance (mmH$_2$O) | 150.1 | 150.5 | 150.7 | 150.8 | 151.2 | 165.2 |

From Table 11, it is noticed that the structure has less water-proof property and air permeability, since its pore size is too small.

(Comparative Example 2-3)

One surface of a symmetric porous structure having a porosity of 80%, a thickness of 50 $\mu$m and a pore size of 0.05 to 0.08 $\mu$m was cooled while the other surface was heated as shown in the following Table. The results are shown in Table 12.

[Table 12]

| Heat treatment temperature (°C) | Unheated | 260 | 300 | 340 | 380 | 400 |
|---|---|---|---|---|---|---|
| Thickness of film ($\mu$m) | 47 | 47 | 48 | 48 | 48 | 39 |
| Porosity (%) | 80 | 80 | 81 | 82 | 81 | 55 |
| Pore size ($\mu$m) | 0.05 to 0.08 | 0.04 to 0.08 | 0.03 to 0.08 | 0.02 to 0.08 | 0.02 to 0.08 | 0.01 to 0.03 |
| Water contact angle (°) | 119 | 120 | 126 | 132 | 131 | 119 |
| Frazier air permeability ($\times 10^4 ft^3$/minft$^2$) | 10.2 | 11.1 | 9.8 | 12.1 | 11.2 | 7.1 |
| Frazier air permeability index | 1 | 1.088 | 0.961 | 1.186 | 1.098 | 0.696 |
| Collecting efficiency (%) | 99.24 | 99.49 | 99.94 | 99.99 | 99.99 | 99.99 |
| Water pressure resistance (mmH$_2$O) | 6,500 | 8,600 | > 10,000 | > 10,000 | > 15,000 | > 15,000 |

From Table 12, it is noticed that the structure has less water-proof property and air permeability, since its pore size is too small.

(Comparative Example 3-1)

One surface of a symmetric porous structure having a porosity of 86%, a thickness of 22 $\mu$m and a pore size of 0.20 to 0.45 $\mu$m was cooled while the other surface was heated as shown in the following Table. Further, the obtained asymmetric porous structure was dyed and subjected to oil repellent process. The dyeing was carried out by immersing the structure into a fluoropolymer dye dissolved in isopropanol, and the oil repellent process was carried out by use of a known oil repellent agent. The results are shown in Table 13.

[Table 13]

| Heat treatment temperature (°C) | | unheated | 300 |
|---|---|---|---|
| Thickness of film ($\mu$m) | | 22 | 20 |
| Porosity (%) | | 86 | 86 |
| Pore size ($\mu$m) | | 0.21 to 0.45 | 0.19 to 0.45 |
| Water-proof property (mmH$_2$O) | Before dyeing | 5,500 | 12,000 |
| | After dyeing | 7,000 | 12,500 |
| Gurley number (second) | Before dyeing | 3.9 | 4 |
| | After dyeing | 4.5 | 4.1 |
| Sound transmission loss (dB) | Before dyeing | 0.8 | 1 |
| | After dyeing | 1.2 | 1.1 |
| Sound transmission loss (dB) | Before oil repellent process | 0 | 0 |
| | After oil repellent process | 2 | 4 |

From Table 13, it is noticed that the dyeing and the oil repellent process do not have a significant influence on water-proof property, dust-proof property, sound transmission capability and air permeability.

(Example 3-2)

One surface of a symmetric porous structure having a porosity of 90%, a thickness of 11 $\mu$m and a pore size of 0.72 to 1.3 $\mu$m was cooled while the other surface was heated as shown in the following Table. Further, the obtained asymmetric porous structure was dyed and subjected to oil repellent process. The results are shown in Table 14.

[Table 14]

| Heat treatment temperature (°C) | | unheated | 300 |
|---|---|---|---|
| Thickness of film ($\mu$m) | | 11 | 10 |
| Porosity (%) | | 90 | 90 |
| Pore size ($\mu$m) | | 0.72 to 1.3 | 0.10 to 1.3 |
| Water-proof property (mmH$_2$O) | Before dyeing | 1,000 | 8,000 |
| | After dyeing | 3,000 | 8,500 |
| Gurley number (second) | Before dyeing | 0.3 | 0.5 |
| | After dyeing | 0.7 | 0.5 |
| Sound transmission loss (dB) | Before dyeing | 0.5 | 0.5 |
| | After dyeing | 0.8 | 0.5 |

(continued)

| Sound transmission loss (dB) | Before oil repellent process | 0 | 0 |
|---|---|---|---|
| | After oil repellent process | 2 | 4 |

From Table 14, it is noticed that the dyeing and the oil repellent process do not have a significant influence on water-proof property, dust-proof property, sound transmission capability and air permeability.

(Example 4)

A PTFE porous structure was expanded in the machine direction (MD) at an expanding ratio of 1:8 under an environment of 320°C, and subsequently expanded in the transverse direction (TD) at an expanding ratio of 1:3 under an environment of 320°C. The obtained symmetric porous structure was heated (heating temperature: 270°C) with heated rollers (diameter 250 mm × length 2 m) as shown in Fig. 4 (b) and subsequently expanded in the transverse direction (TD) at an expanding ratio of 1:6 under an environment of 380°C. This asymmetric porous structure was heated (heating temperature: 270°C) with heated rollers (diameter 250 mm × length 2 m) as shown in Fig. 4 (b).

(Example 5)

A PTFE porous structure was expanded in the machine direction (MD) at an expanding ratio of 1:8 under an environment of 320°C, and subsequently expanded in the transverse direction (TD) at an expanding ratio of 1:3 under an environment of 320°C. The obtained symmetric porous structure was heated (heating temperature: 270°C) with heated rollers (diameter 250 mm × length 2 m) as shown in Fig. 4 (b) and subsequently expanded in the transverse direction (TD) at an expanding ratio of 1:5 under an environment of 380°C. This asymmetric porous structure was heated (heating temperature: 270°C) with heated rollers (diameter 250 mm × length 2 m) as shown in Fig. 4 (b). The results are shown in Table 15.

(Example 6)

A PTFE porous structure was expanded in the machine direction (MD) at an expanding ratio of 1:8 under an environment of 320°C, and subsequently expanded in the transverse direction (TD) at an expanding ratio of 1:3 under an environment of 320°C. The obtained symmetric porous structure was heated (heating temperature: 270°C) with heated rollers (diameter 250 mm × length 2 m) as shown in Fig. 4 (b) and subsequently expanded in the transverse direction (TD) at an expanding ratio of 1:3 under an environment of 380°C. This asymmetric porous structure was heated (heating temperature: 270°C) with heated rollers (diameter 250 mm × length 2 m) as shown in Fig. 4 (b). The property of the obtained asymmetric porous structure was evaluated. The results are shown in Table 15.

(Example 7)

A PTFE porous structure was expanded in the machine direction (MD) at an expanding ratio of 1:8 under an environment of 320°C, and subsequently expanded in the transverse direction (TD) at an expanding ratio of 1:3 under an environment of 320°C. The obtained symmetric porous structure was heated (heating temperature: 270°C) with heated rollers (diameter 250 mm × length 2 m) as shown in Fig. 4 (b) and subsequently expanded in the transverse direction (TD) at an expanding ratio of 1:3 under an environment of 380°C. This asymmetric porous structure was heated (heating temperature: 270°C) with heated rollers as shown in Fig. 4 (b). The property of the obtained asymmetric porous structure was evaluated. The results are shown in Table 15.

(Example 8)

A PTFE porous structure was expanded in the machine direction (MD) at an expanding ratio of 1:8 under an environment of 320°C, and subsequently expanded in the transverse direction (TD) at an expanding ratio of 1:10 under an environment of 320°C. The obtained symmetric porous structure was heated (heating temperature: 270°C) with heated rollers (diameter 250 mm × length 2 m) as shown in Fig. 4 (b). The property of the obtained asymmetric porous structure was evaluated. The results are shown in Table 15.

(Comparative Example 1)

A PTFE porous structure was expanded in the machine direction (MD) at an expanding ratio of 1:8 under an environment of 320°C, and subsequently expanded in the transverse direction (TD) at an expanding ratio of 1:6 under an environment of 320°C. The property of the obtained symmetric porous structure was evaluated. The results are shown in Table 15.

(Comparative Example 2)

A PTFE porous structure was expanded in the machine direction (MD) at an expanding ratio of 1:8 under an environment of 320°C, and subsequently expanded in the transverse direction (TD) at an expanding ratio of 1:6 under an environment of 320°C. The property of the obtained symmetric porous structure was evaluated. The results are shown in Table 15.

[0 0 0 1]

[Table 15]

| | Two time expanding in the transverse direction (asymmetric film) | | | Single expanding in the transverse direction (asymmetric film) | Symmetric film | |
|---|---|---|---|---|---|---|
| | Example 5 | Example 6 | Example 7 | Example 8 | Comparative Example 1 | Comparative Example 2 |
| Average pore size ($\mu$m) | 1.0 | 0.7 | 0.5 | 1.2 | 1.0 | 1.0 |
| Pore size ($\mu$m) | 1.2 | 0.9 | 0.7 | 1.5 | 1.3 | 1.4 |
| Porosity (%) | 91 | 87 | 88 | 77 | 88 | 93 |
| Thickness ($\mu$m) | 18 | 19 | 19 | 25 | 20 | 22 |
| Frazier air permeability ($10^4 ft^3$/minft$^2$) | 51.4 | 45.4 | 36.1 | 39.2 | 27.2 | 36.1 |
| Water pressure resistance (mmH$_2$O) | 14,000 | 14,000 | 15,000 | 14,000 | 5,000 | 3,000 |
| Gurley number (second) | 0.6 | 0.7 | 1.1 | 0.8 | 0.9 | 0.5 |
| Sound transmission loss (dB) | 0.5 | 0.6 | 1.1 | 0.7 | 0.4 | 0.5 |

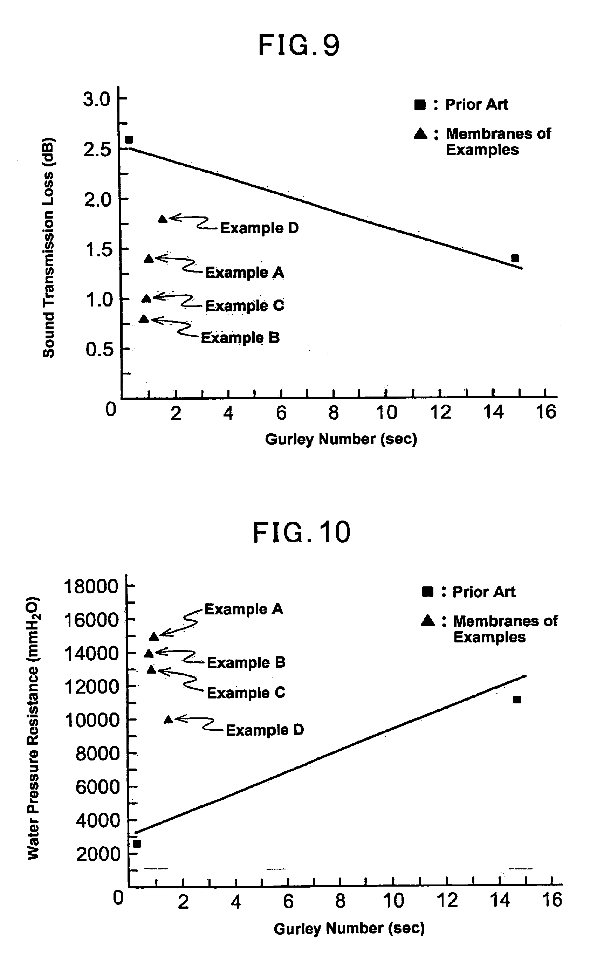

In addition, regarding Examples 5 to 8 (Examples A to D in the drawings), the relation between Gurley number and sound transmission coefficient and the relation between Gurley number and water pressure resistance were evaluated. The results are shown in Figs. 9 and 10. In Figs. 9 and 10, the symbol ■ shows the case where a conventional film is used. From Fig. 9, it can be noticed that the sound transmission loss decreases as the Gurley number increases (the amount of air permeation decreases) in the conventional film. On the other hand, in the symmetric film of the present invention, it is noticed that the air permeability is large and the sound transmission loss is small. Further, from Fig. 10, it is noticed that the water pressure resistance increases as the Gurley number increases (the amount of air permeation decreases) in the conventional film. On the other hand, in the symmetric film of the present invention, it is noticed that the air permeability is large and the water pressure resistance is also large.

From the above, it is recognized that air permeability, sound transmission capability and water pressure resistance are good when the water-proof and dust-proof membrane assembly of the present invention is used.

Additionally, it is also recognized that the heating process may be once or twice.

Explanation of Symbols

10        Water-proof and dust-proof membrane assembly

11        Body

12        Supporting member

13        Porous structure

14        Heated roller

20        Cell phone

21        Housing

22        Opening

30        Underwater digital camera

31        Housing

32        Opening

40        Lighting system

41        Hollow housing

42        Cover

43        Light source device

50        Container

51        Hollow housing

52        Cap

111       First surface

112       Second surface

113       Asymmetric porous structure

121       First contact surface

122       Second contact surface

221       Transceiver

222       Speaker

223    Microphone

411    Window portion

421    Opening

511    Window portion

521    Opening

1131    Skin layer

1132    Porous layer

**Claims**

1.  A water-proof and dust-proof membrane assembly having a body and a supporting member,
    wherein the body is an asymmetric porous structure in the form of membrane having a first surface and a second surface,
    the asymmetric porous structure has a thickness of 1 to 1000 $\mu$m, a porosity (first porosity) of 5% to 90%, a pore size of each pore is 0.01 $\mu$m to 15 $\mu$m, a Frazier air permeability of $10 \times 10^4 ft^3/minft^2$ to $60 \times 10^4 ft^3/minft^2$ and a Gurley number of 0.3 to 25 seconds, the supporting member is composed of a polymeric material, includes a first contact surface and a second contact surface and a porosity (second porosity) of the supporting member is larger than the first porosity, i.e. 10% to 99.9%, and
    the first surface of the body and the first contact surface of the supporting body are bonded.

2.  The water-proof and dust-proof membrane assembly of the claim 1, wherein the asymmetric porous structure has a skin layer and a continuously foamed porous layer and the skin layer makes up 0.04 to 40% of the thickness of the asymmetric porous structure.

3.  The water-proof and dust-proof membrane assembly of the claim 2, wherein the water contact angle of the skin layer is 120° to 135°.

4.  The water-proof and dust-proof membrane assembly of the claim 2, wherein the asymmetric porous structure has the skin layer on either of the first surface or the second surface.

5.  The water-proof and dust-proof membrane assembly of the claim 2, wherein the asymmetric porous structure has the skin layers on the both sides of the first surface and the second surface.

6.  The water-proof and dust-proof membrane assembly of the claim 1, wherein the asymmetric porous structure is produced by heat-treating a symmetric porous structure and the variation of the Frazier air permeability thereof after the heat treatment is 1.1 to 2.5 times that before the heat treatment.

7.  The water-proof and dust-proof membrane assembly of the claim 1, wherein the collecting efficiency of the asymmetric porous structure is 99.50 to 99.99%.

8.  The water-proof and dust-proof membrane assembly of the claim 2, wherein the water-proof and dust-proof membrane assembly using the asymmetric porous structure in which the skin layer is provided on either of the first surface side or the second surface side has a water pressure resistance of 3,000 to 20,000 mmH$_2$O, an air permeability of 0.42 to 6.1 cm$^3$/cm$^2$/sec., and a sound transmission loss of 0.5 to 2.5 dB.

9.  The water-proof and dust-proof membrane assembly of the claim 2, wherein the water-proof and dust-proof membrane assembly using the asymmetric porous structure in which the skin layer is provided on the first surface side and the second surface side has a water pressure resistance of 5,000 to 20,000 mmH$_2$O, an air permeability of 0.1 to 0.34 cm$^3$/cm$^2$/sec., and a sound transmission loss of 0.5 to 2.5 dB.

10. The water-proof and dust-proof membrane assembly of the claim 1, wherein the body is formed by a film selected from a resin porous film or a fluorine polymer film.

11. The water-proof and dust-proof membrane assembly of the claim 9, wherein the resin porous film is an ultrahigh molecular weight polyethylene porous film or a polytetrafluoroethylene film.

12. The water-proof and dust-proof membrane assembly of the claim 9, wherein the fluorine polymer film is a partially fluorinated polymer or a completely fluorinated polymer.

13. An electronic device comprising a housing and at least one electronic circuit component,
    wherein the housing has at least one opening and
    the water-proof and dust-proof membrane assembly of any of the claims 1 to 11 is located over the opening.

14. A lighting system comprising a hollow housing, a cover and at least one light source device,
    wherein the hollow housing has a window portion mating with the cover, the cover has at least one opening,
    the at least one light source device is located inside the hollow housing, being fitted for the at least one opening and
    the water-proof and dust-proof membrane assembly of any of the claims 1 to 11 is located over the opening.

15. A container comprising a hollow housing and a cover,
    wherein the hollow housing has a window portion mating with the cover, the cover has at least one opening and
    the water-proof and dust-proof membrane assembly of any of the claims 1 to 11 is located over the opening.

# FIG. 1

# FIG. 2

# FIG.3

# FIG. 4

(a)

(b)

# FIG.5

(a)

222   22   221

22

21

20

22   223

(b)

10   22   10

22

21

20

22   10

# FIG.6

30

10

32

31

# FIG.7

40

10   42

421

411

41

43

# FIG.8

## FIG.9

## FIG.10

Europäisches
Patentamt

European
Patent Office

Office européen
des brevets

## EUROPEAN SEARCH REPORT

Application Number

EP 11 17 5214

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 464 381 A1 (YEU MING TAI CHEMICAL IND CO L [TW]) 6 October 2004 (2004-10-06) | 1-12 | INV. B01D39/16 B01D69/02 B01D69/10 B01D71/26 B01D71/36 B29K105/04 F21S4/00 H05K5/03 |
| Y | * pages 1,7-56; claims; examples * | 13-15 | |
| Y | JP 2001 168543 A (NITTO DENKO CORP) 22 June 2001 (2001-06-22) * abstract * * paragraphs [0001] - [0004]; claims; figures; examples * | 1-15 | |
| Y | US 2003/089660 A1 (HUANG JAMES [TW] ET AL) 15 May 2003 (2003-05-15) * paragraphs [0001], [0004] - [0017], [0039] - [0064]; claims; examples * | 1-15 | |
| A | DATABASE WPI Week 200604 Thomson Scientific, London, GB; AN 2006-032124 XP002678256, -& JP 2005 334758 A (NITTO DENKO CORP) 8 December 2005 (2005-12-08) * abstract * * claims; examples * | 1-15 | TECHNICAL FIELDS SEARCHED (IPC) B01D B29K B29L F21S H05K |
| A | JP 2000 140587 A (TONEN TAPIRUSU KK; MSA JAPAN LTD) 23 May 2000 (2000-05-23) * abstract * | 1-15 | |

The present search report has been drawn up for all claims

| Place of search | Date of completion of the search | Examiner |
|---|---|---|
| Munich | 21 June 2012 | Otegui Rebollo, Juan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 11 17 5214

This annex lists the patent family members relating to the patent documents cited in the above-mentioned European search report.
The members are as contained in the European Patent Office EDP file on
The European Patent Office is in no way liable for these particulars which are merely given for the purpose of information.

21-06-2012

| Patent document cited in search report | | Publication date | Patent family member(s) | | | Publication date |
|---|---|---|---|---|---|---|
| EP 1464381 | A1 | 06-10-2004 | CN | 1533882 | A | 06-10-2004 |
| | | | EP | 1464381 | A1 | 06-10-2004 |
| | | | HK | 1067098 | A1 | 06-07-2007 |
| | | | JP | 3795027 | B2 | 12-07-2006 |
| | | | JP | 2004305812 | A | 04-11-2004 |
| | | | US | 2004195173 | A1 | 07-10-2004 |
| JP 2001168543 | A | 22-06-2001 | JP | 4137325 | B2 | 20-08-2008 |
| | | | JP | 2001168543 | A | 22-06-2001 |
| US 2003089660 | A1 | 15-05-2003 | JP | 3580790 | B2 | 27-10-2004 |
| | | | JP | 2003138047 | A | 14-05-2003 |
| | | | US | 2003089660 | A1 | 15-05-2003 |
| JP 2005334758 | A | 08-12-2005 | NONE | | | |
| JP 2000140587 | A | 23-05-2000 | NONE | | | |

EPO FORM P0459

For more details about this annex : see Official Journal of the European Patent Office, No. 12/82